# EUROPÄISCHE PATENTSCHRIFT

(11) **EP 1 711 745 B1**
(45) Veröffentlichungstag und Bekanntmachung des Hinweises auf die Patenterteilung: **04.08.2010**
(21) Anmeldenummer: 05701167.8
(22) Anmeldetag: 25.01.2005
(51) Int. Cl.: F24C 7/08, H03K 17/96, H01H 13/70

(54) **BEDIENEINRICHTUNG FÜR EIN ELEKTROGERÄT MIT EINEM BEDIENFELD UND EINEM SENSORELEMENT DARUNTER SOWIE VERFAHREN ZUM BETRIEB DER BEDIENEINRICHTUNG**
OPERATING DEVICE FOR AN ELECTRICAL APPLIANCE HAVING A CONTROL PANEL AND SUBJACENT SENSOR ELEMENT AND METHOD OF OPERATING SUCH AN OPERATING DEVICE
DISPOSITIF DE COMMANDE POUR UN APPAREIL ELECTRIQUE COMPRENANT UN TABLEAU DE COMMANDE ET UN ELEMENT DE DETECTION SITUE EN-DESSOUS ET PROCEDE POUR FAIRE FONCTIONNER LEDIT DISPOSITIF DE COMMANDE

(30) Priorität: 02.02.2004 DE 102004005952
(43) Veröffentlichungstag der Anmeldung: 18.10.2006
(73) Patentinhaber: E.G.O. ELEKTRO-GERÄTEBAU GmbH, D-75038 Oberderdingen (DE)
(72) Erfinder: BAIER, Martin, 76275 Ettlingen (DE)
(74) Vertreter: Patentanwälte Ruff, Wilhelm, Beier, Dauster & Partner
(86) Internationale Anmeldenummer: PCT/EP2005/000706
(87) Internationale Veröffentlichungsnummer: WO 2005/073634

(56) Entgegenhaltungen:
- EP-A- 0 578 019
- WO-A-03/081411
- WO-A1-03/025961
- DE-A1- 10 103 563
- US-A- 5 053 585
- US-A- 5 995 877
- US-B1- 6 429 668

## Beschreibung

Die Erfindung betrifft eine Bedieneinrichtung für ein Elektrogerät, vorzugsweise ein Haushaltsgerät, sowie ein Verfahren zur Auswertung bzw. zum Betrieb einer solchen Bedieneinrichtung.

Es ist aus dem Stand der Technik bekannt, beispielsweise aus der DE-A-19645678 oder der DE-A-19811372, für ein Elektrogerät oder Haushaltsgerät eine Bedien-Blende vorzusehen, unter der an einer bestimmten Stelle, welche ein sogenanntes Bedien-Feld bildet, ein druckempfindliches Piezo-Element angeordnet ist. Wird auf die Abdeckung, welche beispielsweise aus dünnem Edelstahl oder Aluminium bestehen kann, gedrückt, so kann dieses Drücken durch das Piezo-Element als gewünschte Bedienung ausgewertet werden. Eine zugeordnete Auswertung oder Steuerung gibt ein Signal an das Elektrogerät. Als nachteilig wird hierbei angesehen, dass die Verwendung von Piezo-Elementen gewisse Nachteile mit sich bringt, insbesondere, weil diese teilweise mechanisch anfällig sind und nicht leicht in ein Gerät eingebaut werden können. Des weiteren müssen oftmals Sonderanfertigungen bzw. Sonderbauteile von Piezo-Elementen eingesetzt werden, was den Aufwand, insbesondere Kosten und kurzfristige Verfügbarkeit, weiter negativ beeinträchtigt. Der Einsatz anderer Sensorelemente wie kapazitiver oder optischer Sensorelemente weist den Nachteil auf, dass diese entweder derzeit noch nicht bzw. nur mit sehr großem Aufwand hinter metallischen Bedienblenden eingesetzt werden können oder für ein optisches System eine optische Durchlässigkeit unerlässlich ist.

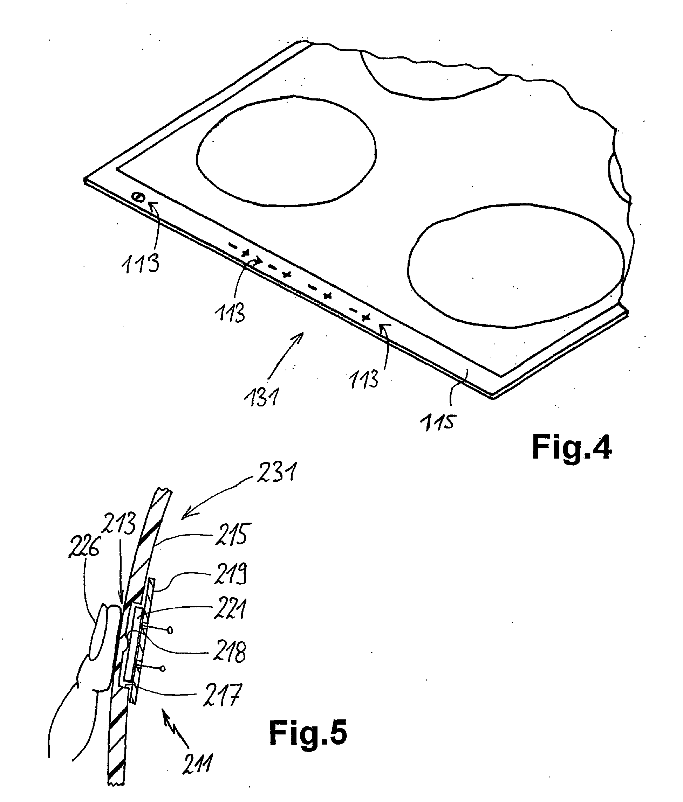

Die EP-A-0578019 beschreibt einen Drucksensor mit variablem Widerstand, der von einer darauf ausgeübten Druckkraft abhängt. Gemäß der Figuren 5 bis 7 kann mit einem Finger direkt auf einen solchen Drucksensor, bestehend aus einer Lage aus interdigitierenden Elektroden mit einer Lage aus Halbmaterial darauf, gedrückt und eine Position der Berührung mit dem Finger ermittelt werden. Diese beiden Lagen können auf einem Bildschirm vorgesehen sein oder auch als Fernbedienung.

Die WO 03/025961 A1 beschreibt ein Schaltelement in Folienbauweise. Unter einer Trägerfolie 12 sind teilweise Abstandshalter 16 angebracht und auf diesen wiederum eine Trägerfolie. In dem Bereich zwischen zwei Abstandshaltern können die Trägerfolien aufeinander gedrückt werden, wodurch Druck auf ein Bauteil aus dilektrischem Material ausgeübt wird. Dadurch wird ein FSR-Sensor gebildet.

### Aufgabe und Lösung

Der Erfindung liegt die Aufgabe zugrunde, eine eingangs genannte Bedieneinrichtung sowie ein eingangs genanntes Verfahren dafür zu schaffen, mit denen die Nachteile des Standes der Technik vermieden werden können und insbesondere eine Bedieneinrichtung geschaffen und verwendet werden kann, die mit geringem herstellerseitigen Aufwand aufgebaut werden kann und möglichst aus Standardbauteilen besteht.

Diese Aufgabe wird gelöst durch eine Bedieneinrichtung mit den Merkmalen des Anspruchs 1 sowie ein Verfahren zur Auswertung einer solchen Bedieneinrichtung mit den Merkmalen des Anspruchs 10. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß erfolgt die Bedienung durch Drücken, beispielsweise in Form eines Auflegens eines Fingers mit gewissem Druck, auf ein Bedien-Feld. Das Bedien-Feld ist formveränderlich oder elastisch, so dass es nach unten nachgeben kann und einen gewissen Bedienweg ergibt. Unter dem Bedien-Feld ist ein druckempfindliches Sensorelement angeordnet, welches den Druck bzw. den Bedienweg erfasst, was gegebenenfalls als Bedienung ausgewertet wird. Als Sensorelement wird erfindungsgemäß ein FSR-Sensor verwendet, wobei FSR für Force Sensing Resistor steht, also insbesondere einen veränderlichen elektrischen Widerstand aufweist. Besonders vorteilhaft kann dabei vorgesehen sein, dass sich bei zunehmendem Druck der elektrische Widerstand des FSR-Sensors verringert. Dies wird nachstehend noch weiter erläutert.

Somit wandelt die Bewegung des Bedien-Feldes aufgrund des Drucks durch den Bediener, welcher auf den FSR-Sensor einwirkt, dies in ein von dem Sensor erzeugtes elektrisches Signal bzw. die Veränderung eines anliegenden Signals um. Dieses wiederum kann durch eine entsprechende Steuerung oder dergleichen als Bedienung ausgewertet werden.

Der große Vorteil eines solchen FSR-Sensors besteht darin, dass aufwendige und teilweise mechanisch empfindliche Piezo-Elemente vermieden werden können. Des weiteren ist ein FSR-Sensor in der Regel aus Kunststoff ausgebildet, insbesondere in Folienform, so dass er mechanisch wenig empfindlich ist und auch unanfällig gegen Korrosion ist. Des weiteren kann ein solcher FSR-Sensor sehr dünn ausgeführt sein, so dass sich durch seine Bauhöhe der Aufbau der Bedieneinrichtung leicht und platzsparend durchführen lässt.

Ein FSR-Sensor kann aus zwei Folien als Trägerfolien aufgebaut werden, wobei auf der einen eine leitende Struktur aufgetragen ist, die verschränkte Metallfinger aufweist. Auf der anderen Folie ist ein halbleitendes Polymer oder dergleichen aufgetragen. Durch eine Trennschicht, einen Abstandshalter oder dergleichen sind die Metallfinger und die Polymer-Schicht mit genau definiertem Abstand getrennt. Zumindest eine der Folienschichten kann eine elektrische Zuleitung aufweisen und sich über die gesamte Zuleitungsvorrichtung bzw. die Länge der elektrischen Zuleitungen erstrecken. Vorteilhaft sind die elektrischen Zuleitungen zwischen zwei Folien nach außen abgeschirmt und elektrisch isoliert angeordnet, wobei dies besonders vorteilhaft die beiden Folien des FSR-Sensors sind.

Erfindungsgemäß bildet das Bedien-Feld einen Teil einer Abdeckung oder einer Blende, welche sich auch über einen größeren, insbesondere weitaus größeren, Bereich des Elektrogeräts erstrecken kann. Es kann beispielsweise ein Rahmen eines Kochfelds sein. Dabei soll erfindungsgemäß das Bedien-Feld bzw. die Abdeckung oder die Blende geschlossen sein bzw. keine Unterbrechungen aufweisen. Insbesondere ist sie nach außen glatt. Durch eine derartige geschlossene Ausbildung ist beispielsweise ein ansprechendes Design sowie eine Widerstandsfähigkeit gegen Wasser oder dergleichen zu erreichen.

Erfindungsgemäß ist das Bedien-Feld oder eine entsprechende Abdeckung oder Blende in einem Bereich über dem Sensorelement elastisch oder dünner ausgeführt als sonst. Dies soll bewirken, dass beispielsweise bei im übrigen dicken Abdeckungen oder Blenden, welche auch eine mechanische Festigkeit bieten sollen und somit gerade ein Durchbiegen möglichst vermeiden sollen, im Bereich des Bedien-Feldes bzw. an den Sensorelementen eine gewisse Eindrückbarkeit ermöglichen. Derartige dünnere Ausführungen können beispielsweise durch Ausnehmungen oder Verdünnungen erreicht werden, welche vorteilhaft auf der Innen- oder Rückseite eines Bedien-Feldes angeordnet sein sollten.

Eine Möglichkeit zur Ausbildung eines Bedien-Feldes oder einer Blende bzw. Abdeckung ist es, sie elektrisch leitfähig zu gestalten bzw. aus dünnem Metall zu bilden. Hier können auch Metallfolien verwendet werden, welche insbesondere wegen ihrer Beständigkeit gegen mechanische Einwirkungen sowie Verschmutzung vorteilhaft sind. Ein bevorzugtes Material ist beispielsweise Edelstahl oder Aluminium.

In weiterer Ausgestaltung der Erfindung ist es möglich, dass das Sensorelement über ein Kopplungselement, welches vorteilhaft elastisch ist, mit dem Bedien-Feld verbunden ist bzw. an dieses angekoppelt ist. Hier kann eine direkte formschlüssige Kopplung vorgesehen sein, welche vorteilhaft an die Unterseite des Bedien-Feldes oder Rückseite führt. Die Elastizität kann als Schutz für das Sensorelement bzw. die gesamte Bedieneinrichtung vorgesehen sein derart, dass bei einer üblichen bestimmungsgemäßen Bedienungskraft das Kopplungselement nicht oder kaum zusammengedrückt wird, also im wesentlichen seine Form und vor allem wirksame Länge beibehält. Erst wenn die Bedienungskraft so stark ansteigt, dass sie die übliche bestimmungsgemäße Kraft weit übersteigt, beispielsweise um den Faktor 2 bis 4 oder mehr, kann sich das Kopplungselement eindrücken bzw. verkürzen. So kann ein Überdrücken und Beschädigen oder Zerstören des Sensorelements verhindert werden. Als Kopplungselement bieten sich grundsätzlich viele elastische Bauteile an. Besonders bevorzugt wird ein Elastomer verwendet. Dieses kann direkt mit dem Sensorelement verbunden sein.

Bei einem Ausführungsbeispiel der Erfindung können mehrere FSR-Sensoren für mehrere Bedien-Felder oder für von den Bedien-Feldern gebildete Bedien-Elemente vorgesehen sein, wobei die Sensoren vorteilhaft zusammenhängend bzw. als Baueinheit ausgebildet sind. Dazu können sie besonders vorteilhaft mechanisch verbundene, jedoch elektrisch getrennte Zuleitungsvorrichtungen aufweisen. Diese können zu einem gemeinsamen Anschluss-Bereich führen, von welchem aus eine elektrische Kontaktierung über Stecker oder sonstige Kontaktiereinrichtungen möglich ist.

Besonders vorteilhaft ist vorgesehen, dass einer der beiden elektrischen Anschlüsse an jeden FSR-Sensor über eine für sich getrennte und separate Zuleitung erfolgt. Der andere elektrische Anschluss kann über eine gemeinsame Rückleitung erfolgen, beispielsweise eine Art gemeinsamen Masseschluss. Ebenso kann bei elektrisch leitenden Bedien-Feldern auch über diese eine Rückleitung erfolgen. Dies weist den Vorteil auf, dass jeder FSR-Sensor direkt daran anliegen kann und somit eine Kontaktierung quasi automatisch gegeben ist.

In weiterer Ausgestaltung der Erfindung kann ein Träger unterhalb des Bedien-Feldes vorgesehen sein. Auf diesem ist der FSR-Sensor angeordnet und vorteilhaft gegenüber dem Bedien-Feld so abgestützt, dass eine Bedienungskraft zwar auf den FSR-Sensor einwirkt, nicht jedoch den Träger durchbiegt. Der Träger ist vorteilhaft eine Leiterplatte. Es kann vorgesehen sein, dass an dem Träger eine elektrische Kontaktierung bzw. Zuleitungen, welche für die Ansteuerung oder Auswertung vorgesehen sind, angeordnet sind. Des weiteren kann der Träger bzw. die Leiterplatte eine Steuerung oder dergleichen aufweisen, welche für den FSR-Sensor vorgesehen ist, beispielsweise auch für das gesamte Elektrogerät.

Bei der Erfindung ist an der Bedieneinrichtung nicht nur ein einziges Bedien-Feld, sondern mehrere Bedien-Felder für verschiedene Funktionen oder separate Funktionseinheiten des Elektrogerätes vorgesehen. Diese Bedien-Felder sind gruppenweise oder nebeneinander in einem Bedien-Bereich angeordnet, welcher zur besonderen Kennzeichnung entsprechend gestaltet sein kann.

Dabei ist erfindungsgemäß eine einstückige und durchgängige Abdeckung vorgesehen, in welcher die Bedien-Felder vorgesehen sind bzw. welche unter anderem den Bedien-Bereich bilden. Dies weist den Vorteil auf, dass der Aufwand geringer gehalten wird und vor allem auch sichergestellt werden kann, dass die Abdeckung wasserfest ist und dergleichen. Es kann eine Art baumförmige FSR-Sensorvorrichtung geschaffen werden, wobei entlang der Äste oder Verzweigungen die elektrischen Zuleitungen zu jedem einzelnen FSR-Sensor verlaufen und diese Sensoren vorteilhaft jeweils am Ende der Verzweigungen, vereinzelt auch dazwischen, angeordnet sind.

Des weiteren ist es vorteilhaft möglich, eine solche Abdeckung als von den FSR-Sensoren separates und leicht abnehmbares Teil auszubilden. Dies bedeutet, dass einerseits, insbesondere auf einem vorbeschriebenen Träger, ein oder mehrere FSR-Sensoren samt Ansteuerung und Auswertung aufgebaut sein können. Darauf kann eine Abdeckung aufgesetzt werden, welche in Varianten unterschiedlich gestaltet werden kann, je nach Design-Vorgaben verschiedener Hersteller oder Verwendungszweck. Dies ist insbesondere bei Abdeckungen aus Metall oder dergleichen von Vorteil.

Alternativ ist es möglich, einen FSR-Sensor an der Abdeckung selber zu befestigen bzw. daraus eine Art Baueinheit zu bilden. Die Seite, auf welche der Bedienungsdruck einwirken soll, kann dann auch auf der von der Abdeckung weg weisenden Seite vorgesehen sein. Somit wird also der FSR-Sensor selber bei der Bedienung gegen einen Träger oder dergleichen gedrückt. Die Anbringung an einer Abdeckung bedeutet jedoch einen in der Regel erhöhten Anschlussaufwand für den FSR-Sensor. Eine Vorkonfektionierung mit fertigem Anschluss an eine Steuerung oder Auswertung ist nur dann möglich, wenn Steuerung oder Auswertung an der Abdeckung angeordnet sind.

Als beispielhafte und vorteilhafte Dimensionierungen kann vorgesehen sein, dass das Bedien-Feld lediglich ein kleines Stück eingedrückt wird zur Bedienung bzw. zur Erkennung durch den FSR-Sensor. Eine Durchbiegung kann maximal 100 µm betragen, vorteilhaft 1 µm bis 10 µm sein. Das dadurch ausgelöste Signal an dem FSR-Sensor kann als eine Art Signalwert oder Schwellenwert angesehen werden. Erst wenn dieses Signal erreicht oder überschritten wird, gilt es als gewollte und bestimmungsgemäße Bedienung, welche dann zur entsprechenden Auslösung als Bedienvorgang führt. Ein derartiges Signal ist für einen Bediener beinahe nicht erfassbar, was jedoch durchaus gewünscht sein kann, da sich dadurch das Bedienverhalten wie bei beispielsweise optischen oder kapazitiven Berührungsschalten ergibt, ohne jedoch deren eingangs genannte Nachteile in Kauf nehmen zu müssen. Als bestimmungsgemäße oder vorgesehene Bedienungskraft können beispielsweise wenige N vorgesehen sein, welche bei entsprechend ausgebildeter Abdeckung oder Bedien-Feld zu der vorgenannten Durchbiegung führen können. Bei einem erfindungsgemäßen Verfahren zur Auswertung der Bedieneinrichtung kann vorgesehen sein, dass durch Drücken auf den Bedien-Bereich zuerst auf den FSR-Sensor gedrückt wird. Nach dem Loslassen stellt er sich zurück. Diese Vorgänge lösen jeweils Signale aus bzw. bilden einen Signalverlauf, der vom grundsätzlichen Verlauf charakteristisch ist. Diese Signale bzw. der Signalverlauf wird ausschließlich dann als Bedienung angesehen, wenn er in vorgegebenen Grenzen liegt. Insbesondere ist es bei einer einfachen Ausgestaltung möglich, nach dem Erreichen des maximalen notwendigen Signals beim Eindrücken für eine bestimmte Zeit, beispielsweise mehr als eine halbe oder eine Sekunde, dieses bereits als Bedienung zu werten.

Bei einer anderen Ausbildung, welche insbesondere ein anderes Bedienungsverhalten sowie eine sicherere Bedienung ergeben soll, kann vorgesehen sein, dass das Signal des Zurückstellens abgewartet wird. Es muss ein bestimmter zeitlicher Abstand zwischen dem Signal des Eindrückens und demjenigen des Zurückstellens liegen. Dieser sollte weniger als 5 Sekunden betragen, vorteilhaft weniger als 2 Sekunden. Dies bedeutet, wenn ein Bediener für eine gewünschte Bedienung auf das Bedien-Feld drückt und instinktiv bzw. übungsgemäß gleich oder kurz danach wieder loslässt, wird dies als Bedienungsvorgang ausgewertet. Legt er jedoch aus Versehen einen etwas schwereren Gegenstand, wie beispielsweise einen Kochtopf bei einem Kochfeld als Elektrogerät, auf dem Bedien-Bereich ab, und verbleibt dieser für eine längere Zeit darauf, so wird dies erkannt und eben keine Bedienung ausgewertet.

Für ein erfindungsgemäßes Verfahren wird der FSR-Sensor also sozusagen nicht als aktiver Sensor, sondern als passiver Sensor verwendet. Durch die Bedienung ändert er seinen elektrischen Widerstand, was durch eine Widerstandsmessung, welche grundsätzlich beliebig erfolgen kann, ermittelt wird. Ein FSR-Sensor ist besonders bevorzugt so ausgebildet, dass er bei einem Bedienweg im vorgenannten Bereich, insbesondere bei ca. 10 µm, der Widerstand um mindestens den Faktor 10 ändert.

Vorteilhaft werden Bedieneinrichtung und Verfahren für ein Elektrohaushaltsgerät wie beispielsweise ein Kochfeld, einen Backofen oder sogenannte Geräte der Weißwaren-Industrie verwendet. Dies sind ansonsten auch noch Waschmaschinen, Trockner oder Spülmaschinen sowie Mikrowellen oder dergleichen.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: einen Querschnitt durch eine erfindungsgemäße Bedieneinrich- tung mit FSR-Sensor,
- Fig. 2: eine Abwandlung einer erfindungsgemäßen Bedieneinrichtung,
- Fig. 3: eine weitere Ausführung einer Sensoranordnung mit einer Viel- zahl von FSR-Sensoren, welche sich baumartig erstreckt,
- Fig. 4: eine Schrägansicht eines Kochfeldes, bei dem im Rahmen eine Bedieneinrichtung ähnlich Fig. 1 integriert ist und
- Fig. 5: einen Schnitt durch eine Kunststoff-Blende eines Trockners mit einer erfindungsgemäßen Bedieneinrichtung.

### Detaillierte Beschreibung der Ausführungsbeispiele

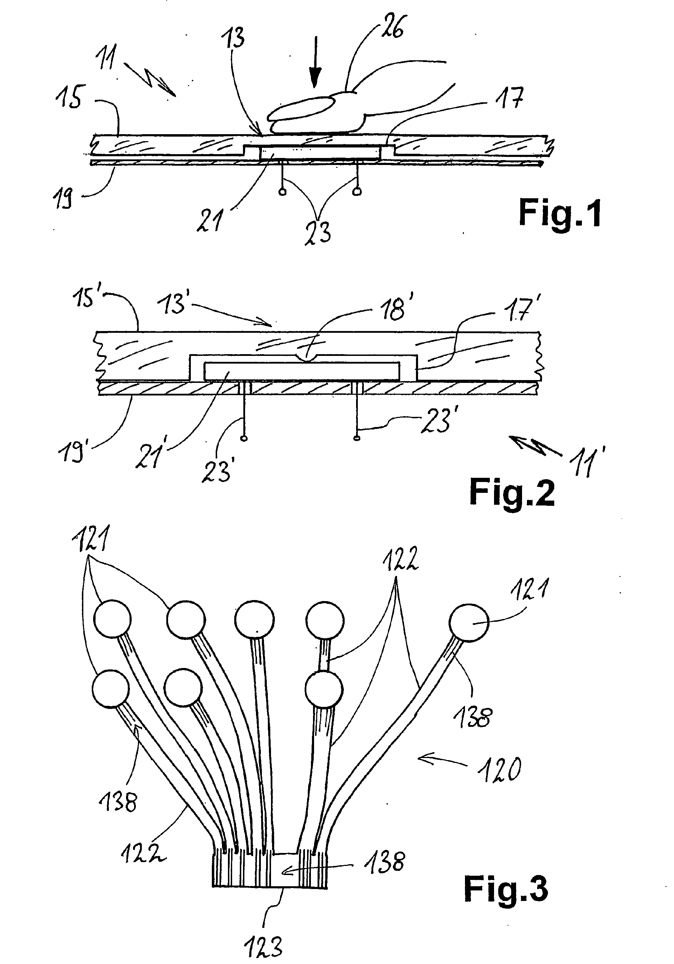

In Fig. 1 ist eine erfindungsgemäße Bedieneinrichtung 11 im Schnitt dargestellt. Sie weist ein Bedien-Feld 13 auf, welches an einer Abdeckung 15 gebildet ist und die Fläche darstellt, auf welche ein Finger 26 zur Bedienung gelegt werden kann. Die Abdeckung 15 weist unterhalb des Bedien-Feldes eine Ausnehmung 17 als Materialverdünnung auf. So ist sichergestellt, dass zumindest im Bereich des Bedien-Feldes 13 ein üblicher Druck aufgrund eines Bedienvorganges oder Auflegen des Fingers 26 eine Durchbiegung nach unten im benötigten Umfang hervorruft.

Unterhalb der Abdeckung 15 verläuft parallel dazu ein Träger 19. Auf diesem ist ein FSR-Sensor 21 angeordnet, der in der Ausnehmung 17 liegt und direkt an der Unterseite der Abdeckung 15 im Bereich des Bedien-Feldes 13 anliegt. Er kann auch angeklebt sein.

Der Träger 19 kann ein beliebiger Träger sein, wobei die elektrischen Anschlüsse 23 des FSR-Sensors 21 hindurch verlaufen oder daran entlang verlegt sein können. Alternativ könnte der Träger 19 eine Leiterplatte sein mit aufgedruckten Leiterbahnen, auf denen Anschlüsse 23 wie bei üblichen elektrischen Bauteilen festgelötet oder sonst kontaktiert werden. Der Träger sollte der Druckkraft, welche die Bedienung auslöst, standhalten.

Wird mit dem Finger 26 auf das Bedien-Feld 13 gedrückt mit einer üblichen Bedienkraft, beispielsweise im Bereich von 2 N, so biegt sich Bedien-Feld 13 durch, sei es aufgrund seines Materials oder einer Ausnehmung 17. Diese Durchbiegung liegt im Bereich weniger µm, beispielsweise 10 bis 40 µm. Diese Durchbiegung überträgt sich direkt auf den FSR-Sensor 21. Somit wird dieser durchgedrückt und je höher der aufgebrachte Druck ist, desto geringer wird der Widerstand des FSR-Sensors 21. In der Regel ist zwar kein linearer Zusammenhang zwischen Druck bzw. Durchbiegung und Veränderung des elektrischen Widerstands gegeben. Es kann jedoch eine einigermaßen genaue Zuordnung zwischen bestimmtem Druck und resultierendem elektrischem Widerstand angegeben werden. Die Kennlinie verläuft in der Regel in etwa exponentiell.

Ein Widerstand eines FSR-Sensors 21 im unbetätigten,Zustand liegt üblicherweise bei über 20 MOhm. Bei maximalem Druck kann er im Bereich von einigen kOhm liegen. Dies ist selbstverständlich von der Bauform sowie den verwendeten leitenden Materialien abhängig.

In Fig. 2 ist eine Abwandlung einer Bedieneinrichtung 11' ähnlich der aus Fig. 1 in Vergrößerung dargestellt. An der Unterseite der Abdeckung 15' im Bereich der Ausnehmung 17' unter dem Bedien-Feld 13' ist ein Vorsprung 18' angeordnet. Vorteilhaft besteht er aus dem Material der Abdeckung bzw. ist einstückig. Der Vorsprung 18' bewirkt einen im wesentlichen punktförmigen Druck bzw. eine Konzentration des Drucks der Bedienung auf den FSR-Sensor 21' in einem kleineren Bereich.

In Fig. 3 ist eine baumartige Sensoranordnung 120 dargestellt, welche einstückig ist und eine Vielzahl von FSR-Sensoren 121 aufweist. Somit kann mit einer solchen Sensoranordnung 120 eine Bedieneinrichtung mit einer entsprechenden Anzahl von Bedien-Feldern 13 geschaffen werden.

Die FSR-Sensoren 121 sind am Ende von Zuleitungen 122 angeordnet. Auf den Zuleitungen 122, welche zu einem Anschlussfeld 123 führen, verlaufen die Elektroden 138, wobei sie in diesem Bereich sozusagen die elektrischen Anschlussleitungen bilden. Die Elektroden 138 sind durch die Striche auf den Zuleitungen 122 angedeutet. Auf dem Anschlussfeld 123 können sie den elektrischen Anschlüssen 23 gemäß Fig. 1 entsprechen und eine Art Kontaktfelder bilden. Eine Kontaktierung hieran kann über entsprechende Einrichtungen, beispielsweise aufliegende Kontaktverbinder oder dergleichen, erfolgen.

Der Vorteil einer Sensoranordnung 120 gemäß Fig. 3 liegt darin, dass sie einstückig ist, was Handhabung und Montage stark vereinfacht, ebenso wie den Anschluss daran. Anstelle eines baumartigen verzweigten Aufbaus ist es auch möglich, diesen entweder zusätzlich auf einer weiteren flächigen Trägerschicht aufzubringen, welche beispielsweise rechteckartig sein kann. Alternativ kann eine der Trägerfolien oder auch beide einen entsprechenden flächigen Verlauf aufweisen.

In Fig. 4 ist ein Kochfeld 131 dargestellt, insbesondere ein sogenanntes Glaskeramik-Kochfeld. Dieses weist auf an sich übliche Art einen umlaufenden Kochfeld-Rahmen 115 auf, der an seiner linken unteren Seite als zu einem Bediener hin weisende Vorderseite ausgebildet ist. Der Rahmen 115 weist verschiedene Bedien-Felder 113 auf, und zwar ganz links in Form eines EIN-/AUS Schalters sowie wie im Mittelbereich als Schalter zur Leistungseinstellung der einzelnen Kochstellen, welche kreisförmig schematisch dargestellt sind. Durch Druck auf die Bedien-Felder 113 kann die jeweils zugeordnete Funktion ausgelöst werden. Vom Aufbau her befindet sich unter dem Kochfeld-Rahmen 115 eine Bedieneinrichtung ähnlich derjenigen aus der Fig. 1. Dabei kann die Oberfläche des Kochfeld-Rahmens 115 bzw. er selber durchgängig aus einer Metallschicht oder Metallplatte bzw. Metallfolie gebildet sein, welche der Abdeckung 15 aus Fig. 1 entspricht. Da der FSR-Sensor 21 gemäß Fig. 1 nur unterhalb der Bedien-Felder 113 vorzusehen ist, kann das Metall im sonstigen Bereich des Kochfeld-Rahmens 115 sozusagen massiv unterfüttert sein. Als Alternative zu einer Ausdünnung einer dickeren Metallschicht von unten kann auch eine Ausdünnung von oben vorgesehen sein. In diesem Fall könnte eine dadurch entstehende Mulde als Strukturierung für ein punktgenaues Anlegen eines Fingers oder dergleichen verwendet werden.

Eine besonders bevorzugte Ausführung der Erfindung einer Bedieneinrichtung 211 ist in Fig. 5 dargestellt. Im Schnitt ist eine leicht gewölbte Blende 231 dargestellt. Die Blende 231 besteht aus Kunststoff und weist eine Ausnehmung 217 hinter einem Bedien-Feld 213 auf. Darin ist ähnlich wie in Fig. 2 ein FSR-Sensor 221 auf einem Träger angeordnet.

Drückt der Finger 226 auf das Bedien-Feld 213, so drückt sich die Blende 231 in diesem Bereich durch. Der in der Ausnehmung 217 an der Unterseite angeformte Vorsprung 218 drückt auf den FSR-Sensor 221 und bewirkt bei diesem eine Widerstandsänderung wie zuvor beschrieben. Diese kann als Bedienung ausgewertet werden.

## Patentansprüche

1. Bedieneinrichtung (11) für ein Elektrogerät (131), vorzugsweise ein Haushaltsgerät, wobei die Bedienung durch Drücken auf ein formveränderliches oder elastisches Bedien-Feld (13, 113) mit einem druckempfindlichen Sensorelement darunter erfolgt, wobei das Sensorelement einen FSR-Sensor (21) aufweist und die Bewegung des Bedien-Feldes (13, 113) in Druck auf den FSR-Sensor und somit in ein als von dem FSR-Sensor (21, 121) erzeugtes elektrisches Signal wandelt, das als Bedienung auswertbar ist, wobei das Bedien-Feld (13, 113), als Teil einer Abdeckung (15, 115) oder Blende geschlossen bzw. unterbrechungsfrei ist, **dadurch gekennzeichnet, dass** das Bedien-Feld (13, 113) oder die Abdeckung bzw. die Blende im Bereich über dem FSR-Sensor (21, 121) elastischer oder dünner ausgeführt ist als im übrigen Bereich, wobei mehrere Bedien-Felder (13, 113) in einem Bedien-Bereich oder nebeneinander angeordnet sind, wobei jeweils die Bedien-Felder bzw. der Bedien-Bereich von einer einstückigen und durchgängigen Abdeckung (15, 115) gebildet werden.

2. Bedieneinrichtung nach Anspruch 1, **dadurch gekennzeichnet, dass** der FSR-Sensor (21, 121) als veränderlicher elektrischer Widerstand ausgebildet und ansteuerbar ist, wobei sich bei zunehmendem Druck der elektrische Widerstand des FSR-Sensors verringert.

3. Bedieneinrichtung nach Anspruch 1 oder 2, **dadurch gekennzeichnet, dass** mehrere FSR-Sensoren (121) zusammenhängend ausgebildet sind, vorzugsweise mit einer verbundenen und elektrisch getrennten Zuleitungsvorrichtung (122), und einen gemeinsamen Anschluss-Bereich (123) aufweisen, wobei insbesondere einer der beiden elektrischen Anschlüsse (138) an jeden FSR-Sensor über eine separate Zuleitung (138) erfolgt und der andere elektrische Anschluss über eine gemeinsame Rückleitung erfolgt.

4. Bedieneinrichtung nach Anspruch 3, **dadurch gekennzeichnet, dass** sich zumindest eine Folienschicht mit mindestens einer elektrischen Leitung (138), vorzugsweise zwei Folienschichten mit der mindestens einen elektrischen Leitung dazwischen, über die gesamte Zuleitungsvorrichtung (122) erstreckt

5. Bedieneinrichtung nach einem der vorhergehenden Ansprüche, **dadurch gekennzeichnet, dass** das Bedien-Feld (13, 113), insbesondere ein Bedien-Bereich, durchgängig elektrisch leitfähig ist oder aus dünnem Metall wie einer Metallfolie oder dergleichen besteht, vorzugsweise aus Edelstahl, wobei insbesondere der FSR-Sensor (21, 121) gegen das Bedien-Feld (13, 113) oder den Bedien-Bereich isoliert ist.

6. Bedieneinrichtung nach einem der vorhergehenden Ansprüche, **dadurch gekennzeichnet, dass** der FSR-Sensor (21, 121) über ein elastisches Kopplungselement (24) mit dem Bedien-Feld (13, 113) verbunden ist, insbesondere als direkte formschlüssige Kopplung an dessen Unterseite, wobei vorzugsweise die Elastizität derart ist, dass bei einer üblichen bestimmungsgemäßen Bedienungskraft das Kopplungselement nicht oder kaum zusammengedrückt wird und erst bei einer die übliche bestimmungsgemäße Bedienungskraft weit übersteigenden Bedienungskraft zusammengedrückt wird.

7. Bedieneinrichtung nach Anspruch 6, **dadurch gekennzeichnet, dass** das Kopplungselement ein Elastomer (24) ist, das direkt mit dem FSR-Sensor (21, 121) verbunden ist.

8. Bedieneinrichtung nach einem der vorhergehenden Ansprüche, **gekennzeichnet durch** einen Träger (19) unterhalb des Bedien-Feldes (13, 113), vorzugsweise eine Leiterplatte, auf welchem der FSR-Sensor (21, 121) angeordnet ist, wobei insbesondere der Träger die elektrische Kontaktierung (23) und/oder eine Ansteuerung bzw. Auswertung für den FSR-Sensor oder die Bedieneinrichtung (11) aufweist.

9. Bedieneinrichtung nach einem der vorhergehenden Ansprüche, **dadurch gekennzeichnet, dass** ein elektrisches Signal des FSR-Sensors (21, 121) bei einer Durchbiegung des Bedien-Feldes (13, 113) bzw. des FSR-Sensors von 1 - 100 µm, vorzugsweise 1-10 µm, eine Bedienung ist.

10. Verfahren zur Auswertung einer Bedieneinrichtung nach einem der vorhergehenden Ansprüche, **dadurch gekennzeichnet, dass** an dem FSR-Sensor (21, 121) das Eindrücken sowie das anschließende Zurückstellen des FSR-Sensors erfasst wird, wobei erhaltene Signale ausschließlich dann als Bedienung angesehen werden, wenn das Signal aufgrund des Zurückstellens direkt anschließend oder mit sehr kurzem zeitlichem Abstand auf das Signal des Eindrückens erfolgt.

11. Verfahren nach Anspruch 10, **dadurch gekennzeichnet, dass** der zeitliche Abstand weniger als fünf Sekunden beträgt, vorzugsweise weniger als zwei Sekunden.

12. Verfahren nach Anspruch 10 oder 11, **dadurch gekennzeichnet, dass** der FSR-Sensor (21, 121) als veränderlicher Widerstand verwendet wird und mit einer Widerstandsmessung ausgewertet wird, wobei er vorzugsweise derart ausgebildet ist, dass sich bei einem Bedienweg von 10µm der Widerstand um mindestens den Faktor 10 ändert.

## Claims

1. An operating device (11) for an electrical appliance (131), preferably a domestic appliance, operation taking place by pressing on a control field (13, 113) which is of changeable shape or is resilient and which has a pressure-sensitive sensor element beneath it, the sensor element comprising an FSR sensor (21) and converting the movement of the control field (13, 113) into pressure on the FSR sensor and thus into an electrical signal generated as if by the FSR sensor (21, 121), which signal may be evaluated as operation, the control field (13, 113), as part of a cover (15, 115) or panel, being continuous or uninterrupted, **characterised in that** the control field (13, 113) or the cover or panel is more resilient or thinner in the area above the FSR sensor (21, 121) than in the remainder thereof, a plurality of control fields (13, 113) being arranged in a control zone or next to one another, the control fields or the control zone being in each case formed of a one-piece, continuous cover (15, 115).

2. An operating device according to claim 1, **characterised in that** the FSR sensor (21, 121) takes the form of and may be activated as a variable electrical resistor, the electrical resistance of the FSR sensor diminishing as the pressure increases.

3. An operating device according to claim 1 or claim 2, **characterised in that** a plurality of interconnected FSR sensors (121) are provided, preferably with a connected and electrically isolated feed conductor device (122), and comprise a common connection zone (123), wherein in particular one of the two electrical connections (138) to each FSR sensor proceeds via a separate feed conductor (138) and the other electrical connection proceeds via a common return conductor.

4. An operating device according to claim 3, **characterised in that** at least one film layer with at least one electrical conductor (138), preferably two film layers with the at least one electrical conductor therebetween, extends over the entire feed conductor device (122).

5. An operating device according to any one of the preceding claims, **characterised in that** the control field (13, 113), in particular a control zone, is electrically conductive throughout or consists of thin metal such as a metal foil or the like, preferably of stainless steel, wherein in particular the FSR sensor (21, 121) is isolated from the control field (13, 113) or the control zone.

6. An operating device according to any one of the preceding claims, **characterised in that** the FSR sensor (21, 121) is connected via a resilient coupling element (24) to the control field (13, 113), in particular as a direct form-fitting coupling to the underside thereof, wherein the resilience is preferably such that, in the event of a usual, proper operating force, the coupling element is not compressed or is barely compressed and is only compressed in the event of an operating force which far exceeds the usual, proper operating force.

7. An operating device according to claim 6, **characterised in that** the coupling element is an elastomer (24), which is connected directly to the FSR sensor (21, 121).

8. An operating device according to any one of the preceding claims, **characterised by** a support (19) below the operating panel (13, 113), preferably a printed circuit board, on which the FSR sensor (21, 121) is arranged, wherein in particular the support comprises the electrical contacting means (23) and/or an activating or evaluating means for the FSR sensor or the operating device (11).

9. An operating device according to any one of the preceding claims, **characterised in that** an electrical signal of the FSR sensor (21, 121) on bending of the control field (13, 113) or of the FSR sensor by 1-100 µm, preferably 1-10 µm, constitutes operation.

10. A method of evaluating an operating device according to any one of the preceding claims, **characterised in that** the FSR sensor (21, 121) detects pressing in and subsequent resetting of the FSR sensor, wherein the resultant signals are regarded as operation solely when the signal resulting from resetting follows the pressing-in signal directly or after a very short interval.

11. A method according to claim 10, **characterised in that** the interval amounts to less than five seconds, preferably less than two seconds.

12. A method according to claim 10 or claim 11, **characterised in that** the FSR sensor (21, 121) is used as a variable resistor and is evaluated by resistance measurement, wherein it is preferably such that with an operating path of 10 µm the resistance changes by at least the factor 10.

## Revendications

1. Dispositif de commande (11) pour un appareil électrique (131), de préférence un appareil ménager, dans lequel la commande s'effectue par pression sur un tableau de commande (13, 113) déformable ou élastique avec un élément de détection sensible à la pression situé en dessous, sachant que l'élément de détection présente un capteur FSR (21) et transforme le mouvement du tableau de commande (13, 113) en pression sur le capteur FSR et donc en un signal électrique comme généré par le capteur FSR (21, 121) et utilisable comme signal de commande, et que le tableau de commande (13, 113) est fermé ou ininterrompu en tant que partie d'un élément de recouvrement (15, 115) ou d'un écran, **caractérisé en ce que** le tableau de commande (13, 113) ou l'élément de recouvrement ou l'écran est plus élastique ou plus mince dans la zone au-dessus du capteur FSR (21, 121) que dans la zone restante, sachant que plusieurs tableaux de commande (13, 113) sont disposés dans une plage de commande ou côte à côte, et que chaque tableau de commande ou la plage de commande est formé(e) par un élément de recouvrement (15, 115) d'une seule pièce et d'un seul tenant.

2. Dispositif de commande selon la revendication 1, **caractérisé en ce que** le capteur FSR (21, 121) est conçu comme résistance électrique variable et excitable, sachant que la résistance électrique du capteur FSR diminue quand la pression augmente.

3. Dispositif de commande selon la revendication 1 ou 2, **caractérisé en ce que** plusieurs capteurs FSR (121) sont attenants, avec de préférence un dispositif d'alimentation (122) associé et séparé électriquement, et présentent une zone de connexion (123) commune, sachant qu'en particulier l'une des deux connexions électriques (138) sur chaque capteur FSR est réalisée par une conduite d'alimentation distincte (138) et que l'autre connexion électrique est réalisée par un retour commun.

4. Dispositif de commande selon la revendication 3, **caractérisé en ce qu'**au moins une couche de feuille avec au moins une conduite électrique (138), de préférence deux couches de feuille avec l'au moins une conduite électrique entre elles s'étendent sur la totalité du dispositif d'alimentation (122).

5. Dispositif de commande selon l'une des revendications précédentes, **caractérisé en ce que** le tableau de commande (13, 113), en particulier une plage de commande, est sans interruption électroconducteur ou constitué de métal mince, par exemple d'une feuille métallique ou similaire, de préférence en acier spécial, sachant qu'en particulier le capteur FSR (21, 121) est isolé par rapport au tableau de commande (13, 113) ou à la plage de commande.

6. Dispositif de commande selon l'une des revendications précédentes, **caractérisé en ce que** le capteur FSR (21, 121) est relié au tableau de commande (13, 113) par un élément de couplage élastique (24), en particulier comme couplage direct par complémentarité de forme sur sa face inférieure, sachant que de préférence l'élasticité est telle que sous un effort de commande conforme habituel, l'élément de couplage n'est pas ou guère comprimé, et n'est vraiment comprimé que sous un effort de commande largement supérieur à l'effort de commande conforme habituel.

7. Dispositif de commande selon la revendication 6, **caractérisé en ce que** l'élément de couplage est un élastomère (24) qui est relié directement au capteur FSR (21, 121).

8. Dispositif de commande selon l'une des revendications précédentes, **caractérisé par** un support (19) sous le tableau de commande (13, 113), de préférence un carte de circuits imprimés, sur lequel est placé le capteur FSR (21, 121), sachant qu'en particulier le support présente les contacts électriques (23) et/ou une unité d'excitation ou d'analyse pour le capteur FSR ou le dispositif de commande (11).

9. Dispositif de commande selon l'une des revendications précédentes, **caractérisé en ce qu'**un signal électrique du capteur FSR (21, 121) émis lors d'une flexion du tableau de commande (13, 113) ou du capteur FSR comprise entre 1 et 100 µm, de préférence entre 1 et 10 µm, est un signal de commande.

10. Procédé pour analyser un dispositif de commande selon l'une des revendications précédentes, **caractérisé en ce que** sur le capteur FSR (21, 121), la compression ainsi que le retour en position initiale du capteur FSR qui s'ensuit sont détectés, sachant que les signaux reçus ne sont considérés comme signaux de commande que lorsque le signal provoqué par le retour en position initiale suit immédiatement ou après un très court intervalle de temps le signal de la compression.

11. Procédé selon la revendication 10, **caractérisé en ce que** l'intervalle de temps s'élève à moins de cinq secondes, de préférence moins de deux secondes.

12. Procédé selon la revendication 10 ou 11, **caractérisé en ce que** le capteur FSR (21, 121) est utilisé comme résistance variable et analysé avec un mesurage de résistance, sachant qu'il est conçu de manière telle que la résistance varie d'au moins le facteur 10 pour une course de commande de 10 µm.
